(19) Europäisches Patentamt / European Patent Office / Office européen des brevets

(11) **EP 3 775 938 B1**

(12) **EUROPEAN PATENT SPECIFICATION**

(45) Date of publication and mention
of the grant of the patent:
**04.05.2022 Bulletin 2022/18**

(21) Application number: **19716067.4**

(22) Date of filing: **26.03.2019**

(51) International Patent Classification (IPC):
***G01R 15/18*** (2006.01)

(52) Cooperative Patent Classification (CPC):
**G01R 15/181**

(86) International application number:
**PCT/EP2019/025082**

(87) International publication number:
**WO 2019/192757 (10.10.2019 Gazette 2019/41)**

(54) **TEMPERATURE STABLE ROGOWSKI COIL**

TEMPERATURSTABILE ROGOWSKI-SPULE

BOBINE DE ROGOWSKI STABLE EN TEMPÉRATURE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.04.2018 US 201815946762**

(43) Date of publication of application:
**17.02.2021 Bulletin 2021/07**

(73) Proprietor: **Eaton Intelligent Power Limited
Dublin 4 (IE)**

(72) Inventor: **MILLER, Theodore James
Oakdale, Pennsylvania 15071 (US)**

(74) Representative: **Novagraaf Group
Chemin de l'Echo 3
1213 Onex (CH)**

(56) References cited:
| | |
|---|---|
| **CN-U- 201 514 831** | **US-A1- 2006 176 140** |
| **US-A1- 2006 220 774** | **US-A1- 2008 048 646** |
| **US-A1- 2014 159 744** | **US-A1- 2014 320 111** |
| **US-A1- 2017 170 645** | **US-A1- 2017 356 935** |

## Description

BACKGROUND OF THE INVENTION

### Field of the Invention

The disclosed and claimed concept relates to a Rogowski coil and, more specifically, to a temperature stable Rogowski coil as well as a current sensor assembly including such a Rogowski coil.

### Background Information

A Rogowski coil is an electrical device generally used to measure alternating current (AC) or high-speed current pulses in another conductor. A Rogowski coil includes a core about which a helical coil of wire is disposed. In one common embodiment, the core is a toroid. Further, in one common embodiment, the lead from one end of the helical wire returns through the center of the coil to the other end, so that both terminals are at the same end of the coil. This configuration also improves the resistance, or immunity, to external electro-magnetic fields. The whole assembly is then wrapped around another conductor whose current is to be measured. The consistency of the winding density is critical for preserving resistance/immunity to external electro-magnetic fields and low sensitivity to the positioning of the measured conductor. That is, the voltage that is induced in the coil is proportional to the rate of change (derivative) of current in the straight conductor. Thus, the output of the Rogowski coil is usually connected to an electrical (or electronic) integrator circuit to provide an output signal that is proportional to the current. Single-chip signal processors with built-in analog to digital converters are often used for this purpose. Hereinafter, the integrator circuit/signal processor, *i.e.,* the construct that receives the Rogowski coil output, is identified as the "output assembly."

A Rogowski coil in this configuration is sensitive to temperature changes. That is, the core of the Rogowski coil is, typically, made from a non-metallic/non-magnetic body such as, but not limited to, a plastic. A plastic body expands and contracts with changes in temperature. Stated in more formal terms, a plastic body has a high and anisotropic coefficient of linear thermal expansion (hereinafter, and as used herein, "CLTE"). That is, as the temperature changes, a plastic body with a high CLTE changes more than a body with a low CLTE. Further, an anisotropic CLTE means that the changes in the body are not uniform in all directions. For example, a typical high temperature plastic core has a higher CLTE normal to the mold flow (e.g., about 90ppm/degC) and a much lower CLTE parallel to mold flow (e.g., about 15ppm/degC). Thus, a Rogowski coil core with a high CLTE stretches and shrinks as the temperature changes. This is a disadvantage and problem.

That is, the equation for the output of a Rogowski coil is:

$$N * \mu r * \mu 0 * A/l \ * 2 * \pi \ * f * I$$

Where: N = number of turns, $\mu r$ = relative permeability, $\mu 0$ = permeability of free space, A = cross section of the core (typically measured in "squared" length units, *e.g.,* square meters or $m^2$), I = average circumference of the core typically measured in length units, (e.g., meters), f = the frequency of the current in the current carrying conductor measured in Hertz, and I = the applied current in the conductor. In one embodiment, a Rogowski coil has the following characteristics: N=3600, A= $18 \times 10\text{-}6 m^2$, I=0.0254m f=60Hz, u0=4*pi*10-7H/m, ur=8.5. In this configuration, the resulting output of the Rogowski coil is 0.3mV/A.

As such, when the Rogowski coil core changes with the temperature, the configuration of the wire wrapped thereabout also changes. For example, if the Rogowski coil core expands as the temperature increases, the cross section of the core increases. Further, the pitch of the wire coil, *i.e.,* the "turns" or revolutions of the wire over a set length of the core body, changes as well. Thus, the output of the Rogowski coil changes as the temperature changes. As the output device produces an output based on a predetermined configuration of the Rogowski coil, changes in the Rogowski coil core introduce non-linearity into the output. That is, the output transfer ratio changes with temperature.

There is, therefore, a need for a Rogowski coil that is less susceptible to changes in temperature. There is a further need for a Rogowski coil core that is operable with existing Rogowski coils.

US 2014/0159744 A1 discloses an electrical device for measuring alternating current or current pulses including at least one coil of electrically conductive wire being wound around a non-magnetic carrier, where the non-magnetic carrier is made of glass.

US 2006/0176140 A1 discloses a Rogowski coil formed on a toroidal core made of a thermoplastic or another moldable material, the core having a preferably continuous groove or grooves extending around the core. The grooves correspond in size to magnet wire which registers within the grooves to control the specific location of the wires. The grooving may be helical. A return loop can be provided for return path cancellation, or a reverse winding can be added in a direction opposite to the direction of advancement of the main coil. In using the return loop, a resistive network can be added.

US 2006/0220774 A1 discloses a precision printed circuit board based Rogowski coil including a printed circuit board including a first layer and second layer. The printed circuit board defines an aperture for receiving an electrical path therethrough. A first return path is defined about the aperture on the first layer of the printed circuit board, and a second return path-parallel to the first return path-is defined about the aperture on the second layer of the printed circuit board. A plurality of radial paths defined on the first layer of printed circuit board extend between the aperture and the first return path. A plurality of radial paths defined on the second layer of the printed circuit board extend between the aperture and the second return path. Each first layer radial path is connected with an adjacent second layer radial path to form a generally toroidally-shaped winding.

US 2017/0170645 A1 discloses a current measuring sensor of a Rogowski-torus type including a carrier made of a magnetic material and a secondary winding wound on the carrier in order to deliver an electrical signal representative of a current flowing in a conductor passing through the interior of the torus. The carrier is made of a molded rigid plastic material and includes at least one exterior recess distributed over the length of the body of the carrier. The recess includes at least two grooves that are separated by a partition A protecting and measuring device and an electric circuit breaker may include such a current sensor.

US 2014/0320111 A1 discloses a current sensor based on a Rogowski coil characterized in that it comprises a polygonal cross-section tube obtained from of one or more parts of a rigid PCB. The windings that form the Rogowski coil are located on the portions of the rigid PCB which form the flat faces of said polygonal cross-section tube. The one or more parts of the rigid PCB are joined together by means of flexible zones which can bend in the form of an I, said polygonal cross-section tube being designed so that, during its use, the conductor whose current is required to be measured is situated along the tube's longitudinal axis.

US 2008/0048646 A1 discloses a current measurement device using a Rogowski coil having a generally toroidal-shaped core with a first winding in one direction and a second winding forming a return loop. The coil is positioned within a two-piece electrostatic shield. A first piece of the electrostatic shield is a partially donut-shaped member having a U-shaped cross-section. The coil is positioned in the donut-shaped member and covered by an encapsulating material. The first piece includes a slit through the cross-section thereof to prevent an electrical loop around the perimeter thereof. The second piece of the electrostatic shield is flat and has a donut-shaped configuration. The second piece is configured with inside and outside peripheral edges such that only one or none of the inside/outside edges contact the first piece. The second piece also has a cross-sectional slit which is in registry with the slit in the first piece.

CN 201 514 831 A1 discloses a Rogowski coil comprising a frame and a secondary winding. The frame is made of a non-magnetic material containing magnetism in two ten thousandths. The secondary winding is directly adhered on the frame and consists of screw coils which are formed by a metal layer covering the surface of the frame and with processed needless parts. The two ends of the screw coils lead out the terminals of inductive potential. The Rogowski coil has a low expansion coefficient.

US 2017/0356935 A1 discloses a Rogowski-type current sensor. A current measurement coil, and a compensation coil are provided on a same board. The measurement coil and the compensation coil are arranged such that they at least partially overlap by virtue of each repeatedly changing a side of the board.

## SUMMARY OF THE INVENTION

In accordance with the present invention, a Rogowski coil and a current sensor assembly as set forth in claims 1 and 5 is provided. Further embodiments are inter alia disclosed in the dependent claims.

## BRIEF DESCRIPTION OF THE DRAWINGS

A full understanding of the invention can be gained from the following description of the preferred embodiments when read in conjunction with the accompanying drawings in which:

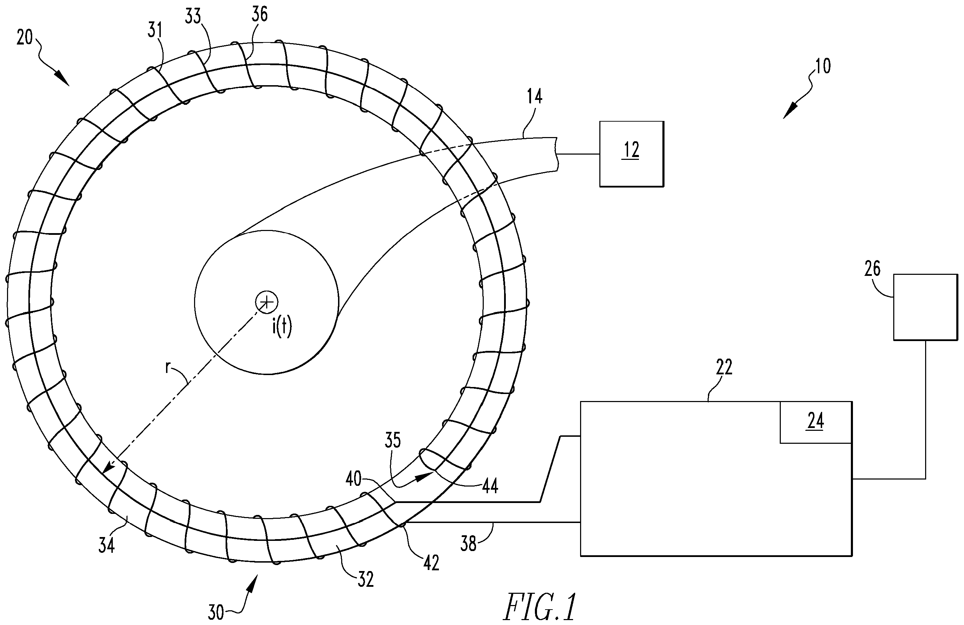

Figure 1 is a schematic view of a current sensor assembly with a Rogowski coil.

## DESCRIPTION OF THE PREFERRED EMBODIMENTS

It will be appreciated that the specific elements illustrated in the figures herein and described in the following specification are simply exemplary embodiments of the disclosed concept, which are provided as non-limiting examples solely for the purpose of illustration. Therefore, specific dimensions, orientations, assembly, number of components used, embodiment configurations and other physical characteristics related to the embodiments disclosed herein are not to be considered limiting on the scope of the disclosed concept.

Directional phrases used herein, such as, for example, clockwise, counterclockwise, left, right, top, bottom, upwards, downwards and derivatives thereof, relate to the orientation of the elements shown in the drawings and are not limiting upon the claims unless expressly recited therein.

As used herein, the singular form of "a," "an," and "the" include plural references unless the context clearly dictates otherwise.

As used herein, "structured to [verb]" means that the identified element or assembly has a structure that is shaped, sized, disposed, coupled and/or configured to perform the identified verb. For example, a member that is "structured to move" is movably coupled to another element and includes elements that cause the member to move or the member is otherwise configured to move in response to other elements or assemblies. As such, as used herein, "structured to [verb]" recites structure and not function. Further, as used herein, "structured to [verb]" means that the identified element or assembly is intended to, and is designed to, perform the identified verb. Thus, an element that is merely capable of performing the identified verb but which is not intended to, and is not designed to, perform the identified verb is not "structured to [verb]."

As used herein, "associated" means that the elements are part of the same assembly and/or operate together, or, act upon/with each other in some manner. For example, an automobile has four tires and four hubcaps. While all the elements are coupled as part of the automobile, it is understood that each hubcap is "associated" with a specific tire.

As used herein, a "coupling assembly" includes two or more couplings or coupling components. The components of a coupling or coupling assembly are generally not part of the same element or other component. As such, the components of a "coupling assembly" may not be described at the same time in the following description.

As used herein, a "coupling" or "coupling component(s)" is one or more component(s) of a coupling assembly. That is, a coupling assembly includes at least two components that are structured to be coupled together. It is understood that the components of a coupling assembly are compatible with each other. For example, in a coupling assembly, if one coupling component is a snap socket, the other coupling component is a snap plug, or, if one coupling component is a bolt, then the other coupling component is a nut.

As used herein, the statement that two or more parts or components are "coupled" shall mean that the parts are joined or operate together either directly or indirectly, *i.e.*, through one or more intermediate parts or components, so long as a link occurs. As used herein, "directly coupled" means that two elements are directly in contact with each other. As used herein, "fixedly coupled" or "fixed" means that two components are coupled so as to move as one while maintaining a constant orientation relative to each other. Accordingly, when two elements are coupled, all portions of those elements are coupled. A description, however, of a specific portion of a first element being coupled to a second element, *e.g.*, an axle first end being coupled to a first wheel, means that the specific portion of the first element is disposed closer to the second element than the other portions thereof. Further, an object resting on another object held in place only by gravity is not "coupled" to the lower object unless the upper object is otherwise maintained substantially in place. That is, for example, a book on a table is not coupled thereto, but a book glued to a table is coupled thereto.

As used herein, the phrase "removably coupled" or "temporarily coupled" means that one component is coupled with another component in an essentially temporary manner. That is, the two components are coupled in such a way that the joining or separation of the components is easy and would not damage the components. For example, two components secured to each other with a limited number of readily accessible fasteners, *i.e.*, fasteners that are not difficult to access, are "removably coupled" whereas two components that are welded together or joined by difficult to access fasteners are not "removably coupled." A "difficult to access fastener" is one that requires the removal of one or more other components prior to accessing the fastener wherein the "other component" is not an access device such as, but not limited to, a door.

As used herein, "temporarily disposed" means that a first element(s) or assembly (ies) is resting on a second element(s) or assembly(ies) in a manner that allows the first element/assembly to be moved without having to decouple or otherwise manipulate the first element. For example, a book simply resting on a table, *i.e.*, the book is not glued or fastened to the table, is "temporarily disposed" on the table.

As used herein, "operatively coupled" means that a number of elements or assemblies, each of which is movable between a first position and a second position, or a first configuration and a second configuration, are coupled so that as the first element moves from one position/configuration to the other, the second element moves between positions/configurations as well. It is noted that a first element may be "operatively coupled" to another without the opposite being true.

As used herein, a "fastener" is a separate component structured to couple two or more elements. Thus, for example, a bolt is a "fastener" but a tongue-and-groove coupling is not a "fastener." That is, the tongue-and-groove elements are part of the elements being coupled and are not a separate component.

As used herein, "correspond" indicates that two structural components are sized and shaped to be similar to each other and may be coupled with a minimum amount of friction. Thus, an opening which "corresponds" to a member is sized slightly larger than the member so that the member may pass through the opening with a minimum amount of friction. This definition is modified if the two components are to fit "snugly" together. In that situation, the difference between the size of the components is even smaller whereby the amount of friction increases. If the element defining the opening and/or the component inserted into the opening are made from a deformable or compressible material, the opening may even be slightly smaller than the component being inserted into the opening. With regard to surfaces, shapes, and lines, two, or more, "corresponding" surfaces, shapes, or lines have generally the same size, shape, and contours.

As used herein, a "path of travel" or "path," when used in association with an element that moves, includes the space an element moves through when in motion. As such, any element that moves inherently has a "path of travel" or "path." Further, a "path of travel" or "path" relates to a motion of one identifiable construct as a whole relative to another object. For example, assuming a perfectly smooth road, a rotating wheel (an identifiable construct) on an automobile generally does not move relative to the body (another object) of the automobile. That is, the wheel, as a whole, does not change its position relative to, for example, the adjacent fender. Thus, a rotating wheel does not have a "path of travel" or "path" relative to the body of the automobile. Conversely, the air inlet valve on that wheel (an identifiable construct) does have a "path of travel" or "path" relative to the body of the automobile. That is, while the wheel rotates and is in motion, the air inlet valve, as a whole, moves relative to the body of the automobile.

As used herein, the statement that two or more parts or components "engage" one another means that the elements exert a force or bias against one another either directly or through one or more intermediate elements or components. Further, as used herein with regard to moving parts, a moving part may "engage" another element during the motion from one position to another and/or may "engage" another element once in the described position. Thus, it is understood that the statements, "when element A moves to element A first position, element A engages element B," and "when element A is in element A first position, element A engages element B" are equivalent statements and mean that element A either engages element B while moving to element A first position and/or element A engages element B while in element A first position.

As used herein, "operatively engage" means "engage and move." That is, "operatively engage" when used in relation to a first component that is structured to move a movable or rotatable second component means that the first component applies a force sufficient to cause the second component to move. For example, a screwdriver may be placed into contact with a screw. When no force is applied to the screwdriver, the screwdriver is merely "temporarily coupled" to the screw. If an axial force is applied to the screwdriver, the screwdriver is pressed against the screw and "engages" the screw. However, when a rotational force is applied to the screwdriver, the screwdriver "operatively engages" the screw and causes the screw to rotate. Further, with electronic components, "operatively engage" means that one component controls another component by a control signal or current.

As used herein, the word "unitary" means a component that is created as a single piece or unit. That is, a component that includes pieces that are created separately and then coupled together as a unit is not a "unitary" component or body.

As used herein, the term "number" shall mean one or an integer greater than one (i.e., a plurality). That is, for example, the phrase "a number of elements" means one element or a plurality of elements. It is specifically noted that the term "a 'number' of [X]" includes a single [X].

As used herein, in the phrase "[x] moves between its first position and second position," or, "[y] is structured to move [x] between its first position and second position," "[x]" is the name of an element or assembly. Further, when [x] is an element or assembly that moves between a number of positions, the pronoun "its" means "[x]," i.e., the named element or assembly that precedes the pronoun "its."

As used herein, "in electronic communication" is used in reference to communicating a signal via an electromagnetic wave or signal. "In electronic communication" includes both hardline and wireless forms of communication; thus, for example, a "data transfer" or "communication method" via a component "in electronic communication" with another component means that data is transferred from one computer to another computer (or from one processing assembly to another processing assembly) by physical connections such as USB, Ethernet connections or remotely such as NFC, blue tooth, etc., and should not be limited to any specific device.

As used herein, "in electric communication" means that a current passes, or can pass, between the identified elements. Being "in electric communication" is further dependent upon an element's position or configuration. For example, in a circuit breaker, a movable contact is "in electric communication" with the fixed contact when the contacts are in a closed position. The same movable contact is not "in electric communication" with the fixed contact when the contacts are in the open position.

As used herein, a "radial side/surface" for a circular or cylindrical body is a side/surface that extends about, or encircles, the center thereof or a height line passing through the center thereof. As used herein, an "axial side/surface" for a circular or cylindrical body is a side that extends in a plane extending generally perpendicular to a height line passing through the center. That is, generally, for a cylindrical soup can, the "radial side/surface" is the generally circular sidewall and the "axial side(s)/surface(s)" are the top and bottom of the soup can. Further, as used herein, "radially extending" means extending in a radial direction or along a radial line. That is, for example, a "radially extending" line extends from the center of the circle or cylinder toward the radial side/surface.

As used herein, "generally curvilinear" includes elements having multiple curved portions, combinations of curved portions and planar portions, and a plurality of planar portions or segments disposed at angles relative to each other thereby forming a curve.

As used herein, an "elongated" element inherently includes a longitudinal axis and/or longitudinal line extending in the direction of the elongation.

As used herein, "about" in a phrase such as "disposed about [an element, point or axis]" or "extend about [an element, point or axis]" or "[X] degrees about an [an element, point or axis]," means encircle, extend around, or measured around. When used in reference to a measurement or in a similar manner, "about" means "approximately," i.e., in an approximate range relevant to the measurement as would be understood by one of ordinary skill in the art.

As used herein, "generally" means "in a general manner" relevant to the term being modified as would be understood by one of ordinary skill in the art.

As used herein, "substantially" means "for the most part" relevant to the term being modified as would be understood by one of ordinary skill in the art.

As used herein, "at" means on and/or near relevant to the term being modified as would be understood by one of ordinary skill in the art.

As used herein "CLTE" means Coefficient of Linear Thermal Expansion. Further, as used herein, a moldable material has a "normal CLTE" and a "parallel CLTE" which means the CLTE normal to the mold flow and the CLTE parallel to the mold flow, respectively. Further, as used herein, a non-moldable material has an "isotropic CLTE" which means that the CLTE is substantially the same and invariant with respect to direction.

As used herein, a "moldable material" means a plastic or similar poly material.

As used herein, a "thermally stable" element, component, or body has a CLTE *(i.e.,* any of normal CLTE, parallel CLTE or isotropic CLTE) of less than 15 ppm/°C.

As shown in Figure 1, an electrical apparatus 10 includes an electrical component 12 and a conductor 14. The conductor 14 transmits energy, *i.e.*, electricity, from a source (or line), not shown, to the electrical component 12 (the load). A sensor assembly 20 is structured to measure current characteristics in the conductor 14. In an embodiment, the sensor assembly 20 includes an output assembly 22 and a Rogowski coil 30. The output assembly 22 is structured to receive an output signal from the Rogowski coil 30 and convert the signal into a representation of current characteristics. In an embodiment, the output assembly 22 includes a programmable logic circuit 24 (hereinafter "PLC 24"). As is known, the PLC 24 is structured to execute a number of commands, a program, or similar construct (hereinafter a module, not shown). The output assembly 22 also includes an output device 26 such as, but not limited to, a screen, gage, or similar construct that is structured to convey information to a human user. The PLC 24 and the output device 26 are in electric, or electronic, communication.

The Rogowski coil 30 includes a core 32 and a winding 31 of a metallic wire 33. In an embodiment, the core 32 is a thermally stable core 32. That is, the core 32 has a CLTE of less than 15 ppm/°C. As discussed below, in one embodiment, a core body 34 is a thermally stable core body 34; in other embodiments, other characteristics/elements of the core 32 make it a thermally stable core 32. As noted, the core 32 includes an encircling body 34, hereinafter "core body" 34. As used herein, an "encircling body" means a body that is structured to, and does, extend about another element. The term "encircling" is not limited to a circular or substantially circular shape. That is, for example, a square hoop is structured to "encircle" another element. In an embodiment, as shown, the core body 34 is a toroid. That is, as shown, the core body 34 has a generally circular local cross-section. As used herein, a "local cross-section" of a toroid body means the cross-section at a location on one side of, and in a plane that includes, the torus axis. Stated alternately, a "local cross-section" is a slice through one side of the toroid body with the plane of the slice including the axis of the torus. So, a generally circular local cross-section means that the shape that is rotated about an axis to create the toroid core body 34 is generally circular. In an embodiment, the inner diameter of the core body 34, *i.e.,* the inner diameter of the torus *(i.e.,* the inner toroid diameter), is about 43,18 mm (1.7 inches) and the outer diameter of the torus *(i.e.,* the outer toroid diameter) is about 62,48 mm (2.46 inches). Thus, the circular shape that defines a generally circular local cross-section has a diameter of about 19,30 mm (0.76 inch). In another embodiment with a generally toroid core body 34, the inner diameter of the torus *(i.e.,* the inner toroid diameter), is about 24,13 mm (0.95 inch) and the outer diameter of the torus *(i.e.,* the outer toroid diameter) is about 26,67 mm (1.05 inches) Thus, the circular shape that defines a generally circular local cross-section has a cross-sectional diameter of about 2,54 mm (0.1 inch).

In another embodiment, the core body 34 is a toroid having a generally rectangular local cross-sectional shape. That is, the inner diameter of the torus is about 22,35 mm (0.88 inch) and the outer diameter of the torus 8 is about 26,67 mm (1.05 inches). . Thus, the local cross-sectional shape has a width of about 2,79 mm (0.11 inch). Further, the local cross-sectional shape has a height of about 6,35 mm (0.25 inch).

As is known, a winding 31 includes an elongated element that is structured to, and does, wrap about the core body 34 in a generally helical manner. In an embodiment, the winding 31 includes the metallic wire 33, such as, but not limited to, a copper wire, disposed generally helically about the core body 34 thereby forming a coil 36. In an embodiment, the wire 33 has a CLTE of about 16ppm/degC. In one exemplary embodiment, not shown, the metallic wire 33 is a small gauge wire such as, but not limited to a 0,127 mm (36 AWG) wire. Turns of the coils 36 are butted against each other and multiple layers of windings are used. In one embodiment wherein the core body 34 is solid, the layers of the coil 36 are alternately wound clockwise and counter-clockwise so that the leads 38, 40 (discussed below) extend from the core body 34 near each other.

In another embodiment, as shown schematically, the core body 34 defines a central passage 35 that extends along a centerline of the core body 34. In this embodiment, the wire 33 has a first end or first lead 38, and, a second end or second lead 40. The first lead 38 transitions into the helical coil 36. That is, the first lead 38 extends from the core body 34 and is contiguous with a first end 42 of the coil 36 (hereinafter "coil first end" 42). The coil 36 extends over 360° of the toroid core body 34 and the coil ends at a second end 44 of the coil 36 (hereinafter "coil second end" 44). The second lead 40 begins at, and is contiguous with, the coil second end 44. The second lead 40 doubles back and extends, generally, through the center of the coil 32 and the core body 34 until radially exiting the coil 32 and the core body 34 at a location adjacent the first lead 38 and/or the coil first end 42. Stated alternately, the second lead 40 returns through the center of the coil 36 to the coil first end 42 and extends radially therefrom. Each of the first lead 38 and the second lead 40 are in electric, or electronic, communication with the output assembly 22. When exposed to an electric current passing through the core body 34 the metallic wire 34, and therefore the Rogowski coil 30, generates an output signal that is communicated to, and through, the first lead 38 and the second lead 40.

According to the invention, the core body 34 is a thermally stable core body 34. That is, the core body 34 has a CLTE of less than about one of 15 ppm/°C, 12 ppm/°C, 10 ppm/°C, or 8 ppm/°C. Further, in one embodiment, the core body 34 has a CLTE of about 7 ppm/°C. Further, in an embodiment, the core body 34 has an isotropic CLTE. As used herein, an "isotropic CLTE" means that the body reacts to changes in temperatures, *i.e.,* the body expands or contracts, substantially equally in all directions. In one embodiment, the core body 34 is a moldable material. Further, in an embodiment, the moldable material is a low CLTE liquid crystal polymer. That is, as used herein, a liquid crystal polymer is included in the definition of a "moldable material." In another embodiment, the core body 34 is a low CLTE ceramic. That is, a ceramic with a CLTE greater than the defined limit of a "thermally stable CLTE" is not an acceptable ceramic. Further, in an embodiment, the ceramic core body 34 ceramic with a CLTE greater than the defined limit of a "thermally stable CLTE" is not an acceptable ceramic. Further, according to the invention, the ceramic core body 34 is made from Steatite L-5™ manufactured by Superior Technical Ceramics Corp., 600 Industrial Park Rd., St. Albans, VT 05478. A data sheet disclosing selected characteristics of Steatite L-5™ is attached as Appendix 1.

While specific embodiments of the invention have been described in detail, it will be appreciated by those skilled in the art that various modifications to those details could be developed in light of the overall teachings of the disclosure. Accordingly, the particular arrangements disclosed are meant to be illustrative only and not limiting. The scope of the invention is defined by the appended claims.

## Claims

1. A Rogowski coil (30) comprising:

   a thermally stable core (32) including an encircling core body (34); and
   a winding (31) including a conductive wire (33);
   wherein the winding (31) is disposed in a generally helical coil (36) about the core body (34);
   wherein the core body (34):

   is thermally stable,
   has an isotropic coefficient of linear thermal expansion, CLTE, of less than one of 15 ppm/°C, 12 ppm/°C, 10 ppm/°C, or 8 ppm/°C, wherein the Rogowski coil is **characterised in that** the core body (34) is made of a thermally stable CLTE ceramic, wherein the ceramic is Steatite L-5.

2. The Rogowski coil (30) of claim 1 wherein the core body (34) has a CLTE of 7 ppm/°C.

3. The Rogowski coil (30) of claim 1, wherein the core body (34):

   has a generally circular cross-sectional shape;
   has a cross-sectional diameter of 2,54 mm (0.1 inch);
   has an inner toroid diameter of 24,13 mm (0.95 inch); and
   has an outer toroid diameter of 26,67 mm (1.05 inches).

4. The Rogowski coil (30) of claim 1 wherein the conductive wire (33) has a CLTE of 16ppm/°C.

5. A current sensor assembly comprising:

   an output assembly (22); and
   a Rogowski coil (30) according to any of claims 1 to 4.

## Patentansprüche

1. Rogowski-Spule (30), umfassend:

   einen thermisch stabilen Kern (32), der einen umgebenden Kernkörper (34) einschließt; und
   eine Wicklung (31), die einen leitfähigen Draht (33) einschließt;
   wobei die Wicklung (31) in einer im Allgemeinen spiralförmigen Spule (36) um den Kernkörper (34) herum angeordnet ist;
   wobei der Kernkörper (34):

   thermisch stabil ist,
   einen isotropen linearen Wärmeausdehnungskoeffizienten, CLTE, von weniger als einem von 15 ppm/°C, 12 ppm/°C, 10 ppm/°C oder 8 ppm/°C aufweist,
   wobei die Rogowski-Spule **dadurch gekennzeichnet ist, dass** der Kernkörper (34) aus einer thermisch stabilen CLTE-Keramik besteht, wobei die Keramik Steatit L-5 ist.

2. Rogowski-Spule (30) nach Anspruch 1, wobei der Kernkörper (34) einen CLTE von 7 ppm/°C aufweist.

**3.** Rogowski-Spule (30) nach Anspruch 1, wobei der Kernkörper (34):

   eine im Allgemeinen kreisförmige Querschnittsform aufweist;
einen Querschnittsdurchmesser von 2,54 mm (0,1 Zoll) aufweist;
einen inneren Toroiddurchmesser von 24,13 mm (0,95 Zoll) aufweist; und
einen äußeren Toroiddurchmesser von 26,67 mm (1,05 Zoll) aufweist.

**4.** Rogowski-Spule (30) nach Anspruch 1, wobei der leitfähige Draht (33) einen CLTE von 16 ppm/°C aufweist.

**5.** Stromsensorbaugruppe, umfassend:

   eine Ausgangsbaugruppe (22); und
eine Rogowski-Spule (30) nach einem der Ansprüche 1 bis 4.

**Revendications**

**1.** Bobine de Rogowski (30) comprenant :

   un noyau thermiquement stable (32) incluant un corps de noyau périphérique (34) ; et
un enroulement (31) incluant un fil conducteur (33) ;
dans laquelle l'enroulement (31) est disposé dans une bobine généralement hélicoïdale (36) autour du corps de noyau (34) ;
dans laquelle le corps de noyau (34) :

      est thermiquement stable,
a un coefficient isotrope de dilatation thermique linéaire, CLTE, inférieur à l'un parmi 15 ppm/°C, 12 ppm/°C, 10 ppm/°C, ou 8 ppm/°C,
dans laquelle la bobine de Rogowski **est caractérisée en ce que** le corps de noyau (34) est constitué d'une céramique CLTE thermiquement stable, dans laquelle la céramique est de la Stéatite L-5.

**2.** Bobine de Rogowski (30) selon la revendication 1 dans laquelle le corps de noyau (34) a un CLTE de 7 ppm/°C.

**3.** Bobine de Rogowski (30) selon la revendication 1, dans laquelle le corps de noyau (34) :

   a une forme en coupe généralement circulaire ;
a un diamètre en coupe de 2,54 mm (0,1 pouce) ;
a un diamètre de tore interne de 24,13 mm (0,95 pouce) ; et
a un diamètre de tore externe de 26,67 mm (1,05 pouce).

**4.** Bobine de Rogowski (30) selon la revendication 1 dans laquelle le fil conducteur (33) a un CLTE de 16 ppm/°C.

**5.** Ensemble capteur de courant comprenant :

   un ensemble de sortie (22) ; et
une bobine de Rogowski (30) selon l'une quelconque des revendications 1 à 4.

FIG.1

EP 3 775 938 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20140159744 A1
- US 20060176140 A1
- US 20060220774 A1
- US 20170170645 A1
- US 20140320111 A1
- US 20080048646 A1
- CN 201514831 A1
- US 20170356935 A1